# FASCICULE DE BREVET EUROPEEN

(11) **EP 2 865 100 B1**
(45) Date de publication et mention de la délivrance du brevet: **12.10.2016**
(21) Numéro de dépôt: 13735227.4
(22) Date de dépôt: 26.06.2013
(51) Int. Cl.: H03M 13/45

(54) **DISPOSITIF DE CORRECTION DE DEUX ERREURS AVEC UN CODE DE DISTANCE DE HAMMING TROIS OU QUATRE**
VORRICHTUNG ZUR KORREKTUR ZWEIER FEHLER MIT EINEM CODE MIT EINER HAMMINGDISTANZ VON DREI ODER VIER
DEVICE FOR CORRECTING TWO ERRORS USING A CODE WITH A HAMMING DISTANCE OF THREE OR FOUR

(30) Priorité: 26.06.2012 FR 1256029; 10.08.2012 FR 1202225
(43) Date de publication de la demande: 29.04.2015
(73) Titulaire: Commissariat à l'Énergie Atomique et aux Énergies Alternatives, 75015 Paris (FR)
(72) Inventeur: EVAIN, Samuel, F-91400 Saclay (FR); GHERMAN, Valentin, F-91120 Palaiseau (FR)
(74) Mandataire: Dudouit, Isabelle
(86) Numéro de dépôt international: PCT/EP2013/063407
(87) Numéro de publication internationale: WO 2014/001397

(56) Documents cités:
- US-A1- 2007 214 402
- US-A1- 2010 017 684
- BACCARINI L ET AL: "Error-correction techniques and adaptive linearization in SDH radio", EUROPEAN CONFERENCE ON RADIO RELAY SYSTEMS. EDINBURGH, OCT. 11 - 14, 1993; LONDON, IEE, GB, vol. CONF. 4, octobre 1993 (1993-10), pages 238-243, XP006513627, ISBN: 978-0-85296-594-8
- SILVERMAN R ET AL: "Coding for constant-data-rate systems", IRE PROFESSIONAL GROUP ON INFORMATION THEORY, IEEE, USA, vol. 1, no. 4, septembre 1954 (1954-09), pages 50-63, XP011217036,

## Description

L'invention a pour objet un dispositif et un procédé pour la correction d'erreurs affectant au moins un bit dans un mot de code dont le nombre de bits de vérifications permet la correction des erreurs simples (c'est-à-dire affectant un seul bit) et, éventuellement, la détection des erreurs doubles (c'est-à-dire les erreurs affectant deux bits). Plus généralement, l'invention propose un dispositif exploitant judicieusement des informations de confiance sur les bits d'un mot de code à corriger, afin de corriger des erreurs de n bits ou plus dans ce mot, le code étant pourvu d'une distance minimale de Hamming inférieure ou égale à 2n, le dispositif assurant également la correction de toutes les erreurs affectant moins de n bits. L'invention s'applique notamment aux domaines des codes correcteurs d'erreurs et des technologies nanométriques.

Dans un système numérique, les données sont habituellement stockées et/ou transmises sous forme de valeurs binaires appelées bits. Ces données peuvent être affectées par des fautes qui peuvent engendrer des erreurs de fonctionnement et finalement la défaillance du système en l'absence de mécanisme de correction ou masquage.

Afin de garantir un niveau d'intégrité acceptable pour les données mémorisées ou transmises, certains systèmes électroniques utilisent des codes, désignés habituellement par l'acronyme ECC venant de l'expression anglo-saxonne « Error Correcting Codes ». A cet effet, les données sont encodées lors de l'écriture desdites données dans un système de stockage ou lors de la transmission desdites données à travers un système d'interconnexions. Lors de l'encodage des données avec un code ECC, des bits de vérification sont ajoutés aux bits de données afin de former des mots de code.

Afin de permettre la correction des erreurs qui affectent jusqu'à n bits dans les mots d'un code ECC, ces mots de code doivent être séparés par une distance minimale de Hamming de 2n+1. Pour permettre également la détection des erreurs qui affectent n+1 bits, en dehors de la correction des erreurs affectant jusqu'à n bits, dans les mots de code d'un ECC, ces mots de code doivent être séparés par une distance minimale de Hamming de 2n+2.

Les mots de code d'un code correcteur linéaire sont définis à l'aide d'une matrice de contrôle H. Un vecteur binaire V est un mot de code seulement si son produit avec la matrice H génère un vecteur nul. Un mot de code V d'un code correcteur linéaire est vérifié en évaluant le produit matriciel H·V. Le résultat de cette opération est un vecteur appelé syndrome. Si le syndrome est un vecteur nul, le mot de code V est considéré comme correct. Un syndrome non-nul indique la présence d'au moins une erreur. Si le syndrome permet d'identifier les positions des bits affectés, les erreurs affectant le mot de code peuvent être corrigées.

Différents codes ECC linéaires existent avec des capacités de détection et de correction d'erreurs différentes. A titre d'exemple, un code de Hamming permet de corriger une erreur simple, c'est-à-dire une erreur qui affecte un seul bit. Cette capacité de correction est qualifiée de SEC, acronyme venant de l'expression anglo-saxonne «Single Error Correction». Les mots d'un code SEC sont séparés par une distance minimale de Hamming de 3.

Un autre exemple de code ECC est le code DEC, acronyme venant de l'expression anglo-saxonne «Double Error Correction», qui permet la correction d'erreurs doubles, c'est-à-dire d'erreurs affectant deux bits dans un mot de code. Bien évidemment, les codes de cette famille sont aussi capables de corriger toutes les erreurs simples. Les mots d'un code DEC sont séparés par une distance minimale de Hamming de 5.

Cette différence entre la capacité de correction d'un code SEC et celle d'un code DEC est due à une augmentation du nombre de bits de vérification dans le cas d'un code DEC. Par exemple, pour huit bits de données un code SEC a besoin de quatre bits de vérification tandis qu'un code DEC a besoin de huit bits de vérification. Une telle augmentation de 100% du nombre de bits de vérification peut être prohibitive en raison de l'impact sur la surface des composants, leur rendement, leur consommation et finalement leur coût.

Or, les mémoires manufacturées à l'aide des technologies émergentes, comme les MRAMs, acronyme venant de l'expression anglo-saxonne «Magnetic Random Access Mémory», peuvent être affectées par un taux important d'erreurs transitoires et/ou permanentes. Pour ces types de mémoires, la capacité de correction des codes SEC est trop faible et les codes DEC restent trop chers. Dans de telles situations, des solutions innovantes de masquage et/ou corrections sont nécessaires.

La demande de brevet US 2010/017684 décrit un procédé de décodage des données basé sur une succession d'opérations de décodage en utilisant une information supplémentaire concernant les erreurs permanentes appelées « hards errors » obtenue lors d'une succession des lectures et écritures supplémentaires dans la mémoire.

La publication de Baccarini intitulée « Error-correction techniques and adaptive linearization in SDH radio » European Conference on Radio Relay Systems, Edinburgh, Oct 11-14, 1993 ; IEEE, GB, conf 4, pages 238-243, XP006513627, décrit une méthode dans laquelle on classifie les bits avec les niveaux de confiance les plus faibles (en Anglais, « least reliable bit » ou LRB), afin de (a) effectuer une succession des opérations de décodage et (b) choisir le résultat situé à la distance Euclidienne minimale du mot reçu.

Le document de Silverman R et al, « Coding for constant-data-rate systems » IRE Professionnal Group on Information Theory, IEEE, USA, vol.1, n°.4, 1 septembre 1954, pages 50-63, XP011217036 propose une méthode de correction des erreurs doubles à l'aide d'un code correcteur dont la distance minimale de Hamming est égale à 4 qui permet la détection des erreurs double. Dans le cas où une erreur double est détectée, les deux bits avec les niveaux de confiance les plus faibles sont inversés.

Un but de l'invention est notamment de proposer des moyens pour corriger une erreur simple ou une erreur multiple sur un mot de code dont la distance minimale de Hamming est égale à 3 ou 4.

A cet effet, l'invention a pour objet un dispositif de correction d'un mot binaire initial affecté d'une erreur sur 1 ou 2 bits et issu d'un code correcteur muni d'une distance minimale de Hamming de 3 ou 4, tel que défini dans la revendication 1.

Le dispositif selon l'invention permet ainsi de corriger des erreurs de 1 ou 2 bits sur des mots de code dont la distance minimale de Hamming est de 3 ou 4.

Ce dispositif permet de réduire le nombre de bits de redondance utilisés par le code. A fortiori, un dispositif analogue apparenté à l'invention mais n'en faisant pas partie fonctionne également pour les codes dont les mots sont séparés d'une distance minimale de Hamming supérieure à 2n, même si son utilisation est alors d'un intérêt plus limité. Le module d'inversion agit comme un module de correction « a priori », les moyens de détection étant utilisés pour sélectionner le mot à fournir en sortie entre celui qui est issu de l'inversion et le mot initial éventuellement corrigé d'une erreur sur n-1 bits.

Le dispositif de correction d'un mot initial peut comprendre un décodeur de plus de 1 bit alimenté par le mot issu du module d'inversion de type premier décodeur, les sorties des deux décodeurs étant combinées pour générer un signal indiquant une erreur qui ne peut être corrigée lorsque les deux moyens de détection ont détecté une erreur de plus de 1 bit.

Selon une variante de réalisation du dispositif, les moyens de détection d'une erreur de plus de 1 bit sont configurés pour détecter des erreurs affectant plus de deux bits qui sont caractérisées par un syndrome non nul et différent des syndromes correspondants à une erreur simple.

Selon l'invention n est égal à 2, les deuxièmes moyens de correction d'une erreur de n-1 bits sont rassemblés sous la forme d'un décodeur SEC.

Lorsque le dispositif pour n égal à 2 comprend des deuxièmes moyens de détection d'erreur de plus de n-1 bits alimentés par le mot issu du module d'inversion et lorsque la distance minimale de Hamming entre les mots de code est égale à 4, les deuxièmes moyens de détection et les deuxièmes moyens de correction peuvent être rassemblés sous la forme d'un décodeur SEC-DED, pour « Single Error Correction-Double Error Detection ».

Similairement, selon un mode de réalisation du dispositif de correction d'un mot initial selon l'invention, dans lequel n est égal à 2 et la distance minimale de Hamming entre les mots de code est égale à 4, les moyens de détection d'une erreur de plus de n-1 bits dans le mot initial et les moyens de correction d'une erreur de n-1 bits dans le mot initial sont rassemblés sous la forme d'un décodeur SEC-DED. Selon un autre mode de réalisation du dispositif de correction d'un mot initial selon l'invention, dans lequel n est égal à 2 est la distance minimale de Hamming entre les mots de code est égale à 3, les moyens de détection d'une erreur de plus de n-1 bits dans le mot initial et les moyens de correction d'une erreur de n-1 bits dans le mot initial sont rassemblés sous la forme d'un décodeur SEC avec détection de certaines erreurs doubles.

Selon un mode de réalisation particulier de l'invention, le dispositif de correction d'un mot initial affecté d'une erreur simple ou d'une erreur double et issu d'un code correcteur muni d'une distance minimale de Hamming égale à 4 comprend une entrée apte à recevoir une donnée indicative de la confiance attribuée à chacun des bits d'au moins une partie du mot initial, ledit dispositif comportant au moins deux décodeurs, un module d'inversion des bits et un multiplexeur, un décodeur SEC-DED recevant en entrée le mot initial, un décodeur SEC ou un décodeur SEC-DED recevant en entrée la sortie du module d'inversion, ledit module d'inversion recevant en entrée ladite donnée indicative de confiance et le mot initial, le multiplexeur choisissant entre les sorties des décodeurs, la sortie du décodeur SEC ou du décodeur SEC-DED étant choisie quand le décodeur SEC-DED indique l'apparition d'une erreur double, le multiplexeur étant contrôlé par un signal fourni par le décodeur SEC-DED indiquant la présence d'une erreur double, le multiplexeur délivrant en sortie le mot corrigé. Ce dispositif permet de corriger des erreurs simples et des erreurs doubles, bien que la distance minimale de Hamming du code utilisé soit seulement égale à 4.

Dans les dispositifs mentionnés ci-dessus, les décodeurs SEC-DED peuvent être construits de façon à assurer aussi la détection des erreurs affectant plus de deux bits qui sont caractérisées par un syndrome non nul et différent des syndromes correspondants à une erreur simple. Ainsi ces dispositifs peuvent assurer la correction de toutes les erreurs détectables dont certaines affectent plus de deux bits.

L'invention a également pour objet un module mémoire comprenant un dispositif tel que décrit plus haut, le module mémoire bénéficiant ainsi de moyens de correction d'erreur performants à moindre coût, puisque le stockage de nombreux bits de redondance est évité.

D'autres caractéristiques et avantages de l'invention apparaîtront à l'aide de la description qui suit, donnée à titre illustratif et non limitatif et faite en regard des dessins annexés parmi lesquels :
- la figure 1, un schéma de principe illustrant la structure d'un dispositif;
- les figures 2a, 2b, 2c illustrent plusieurs mises en oeuvre possibles des moyens de multiplexage et de correction compris dans un dispositif tel que celui présenté en figure 1 ;
- la figure 3, un premier mode de réalisation d'un dispositif selon l'invention apte à corriger des erreurs simples et multiples dans un mot initial de code pourvu d'une distance minimale de Hamming de 3 ou 4 ;
- la figure 4, une variante de réalisation du dispositif présenté en figure 3 apte à détecter des erreurs n'ayant pu être corrigées par le dispositif ;
- la figure 5, un exemple de dispositif apte à corriger des erreurs simples dans un mot de code pourvu d'une distance minimale de Hamming de 2 ;
- la figure 6, une variante du dispositif de la figure 5 apte à détecter des erreurs simples n'ayant pu être corrigées par le dispositif.

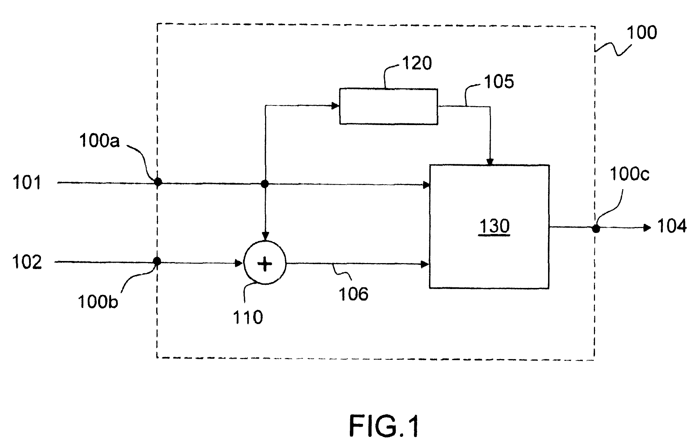

La figure 1 présente un schéma de principe d'un dispositif selon l'invention apte à corriger des erreurs de n bits ou plus dans un mot 101 d'un code caractérisé par une distance minimale de Hamming ne dépasse pas 2n. Ce dispositif assure aussi la correction de toutes les erreurs affectant moins de n bits.

Dans la suite, il est considéré qu'une donnée indicative de confiance, dans l'exemple sous la forme d'un mot 102, est utilisée pour indiquer un niveau binaire de confiance de chaque bit dans un mot de code 101 potentiellement erroné, dit mot initial 101, à l'entrée des dispositifs proposés. Dans les exemples développés, ces mots 101 et 102 comprennent le même nombre de bits. Sans affecter la généralité de l'invention, par la suite, il est également considéré que dans le mot de confiance 102, un bit avec la valeur 1-logique signale que le bit correspondant dans le mot de code 101 a un faible niveau de confiance, un bit avec la valeur 0-logique signalant un bit avec un fort niveau de confiance.

Le dispositif 100 reçoit sur une première entrée 100a un mot initial 101 et sur une deuxième entrée 100b un mot de confiance 102 comprenant l'information binaire relative au niveau de confiance de chaque bit dans le mot initial 101. Le dispositif 100 délivre en sortie 100c un mot corrigé 104. Il comprend des moyens d'inversion de bit 110 alimentés par le mot initial 101 et le mot de confiance 102, des moyens de détection 120 d'une erreur de n bits ou plus dans le mot initial 101 commandant des moyens de multiplexage et de correction 130.

Les moyens d'inversion de bits 110 sont aptes à inverser les bits du mot initial 101 qui sont affectés d'un faible niveau de confiance. Dans l'exemple, les moyens d'inversion de bits comportent un module opérant un « ou exclusif » sur les mots entrants 101 et 102. Ainsi, tous les bits marqués comme faible par un 1-logique sont inversés, de manière à fournir un mot intermédiaire 106.

Les moyens de détection 120 permettent de générer un signal de commande 105 dont la valeur est différente selon qu'ils détectent une erreur sur au moins n bits du mot initial 101. Ainsi si les moyens de détection 120 ne détectent aucune erreur ou s'ils détectent une erreur sur n-1 bits ou moins, alors le signal de commande 105 prend une première valeur ; si les moyens de détection 120 détectent une erreur sur plus de n-1 bits, alors le signal de commande 105 prend une seconde valeur.

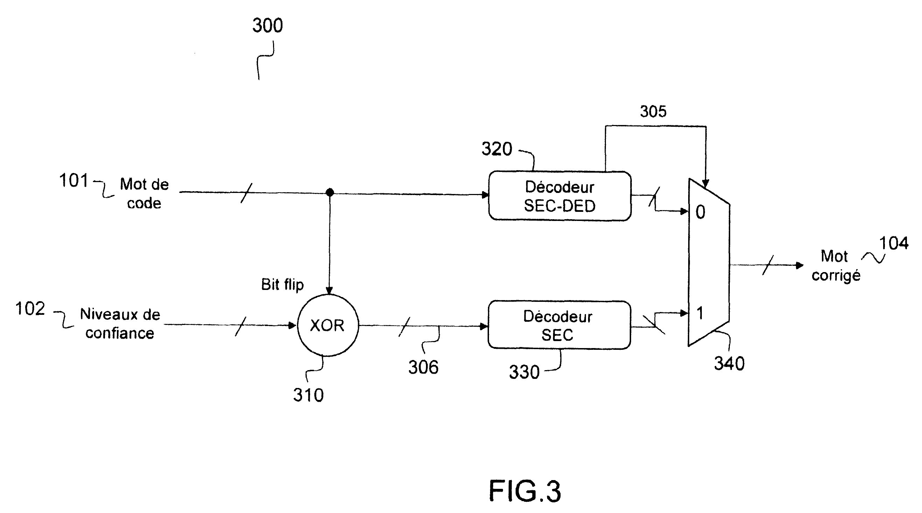

Les moyens de multiplexage et de correction 130 sont alimentés, d'une part par le mot initial 101, et d'autre part par le mot intermédiaire 106 issu des moyens d'inversion 110. En outre, ces moyens 130 sont commandés par le signal de commande 105 issu des moyens de détection 120 de sorte à délivrer un mot corrigé 104 déterminé en fonction du mot initial 101 lorsque le signal de commande 105 est à la première valeur - autrement dit lorsqu'aucune erreur de plus de n-1 bits n'a été détectée sur le mot initial 101 -, et à délivrer un mot corrigé 104 déterminé en fonction du mot intermédiaire 106 lorsque le signal de commande 105 est à la seconde valeur - autrement dit lorsqu'une erreur d'au moins n bits a été détectée sur le mot initial 101. Les moyens de multiplexage et de correction 130 comprennent des moyens de correction d'une erreur sur maximum n-1 bits afin de corriger au moins une telle erreur lorsqu'elle est présente dans le mot initial 101 ou dans le mot intermédiaire 106. Comme illustré plus loin notamment en figure 3, ces moyens de correction peuvent être associés dans le même module physique aux moyens de détection 120 précités. Les moyens de correction et de multiplexage 130 ne correspondent pas nécessairement à un module physique distinct.

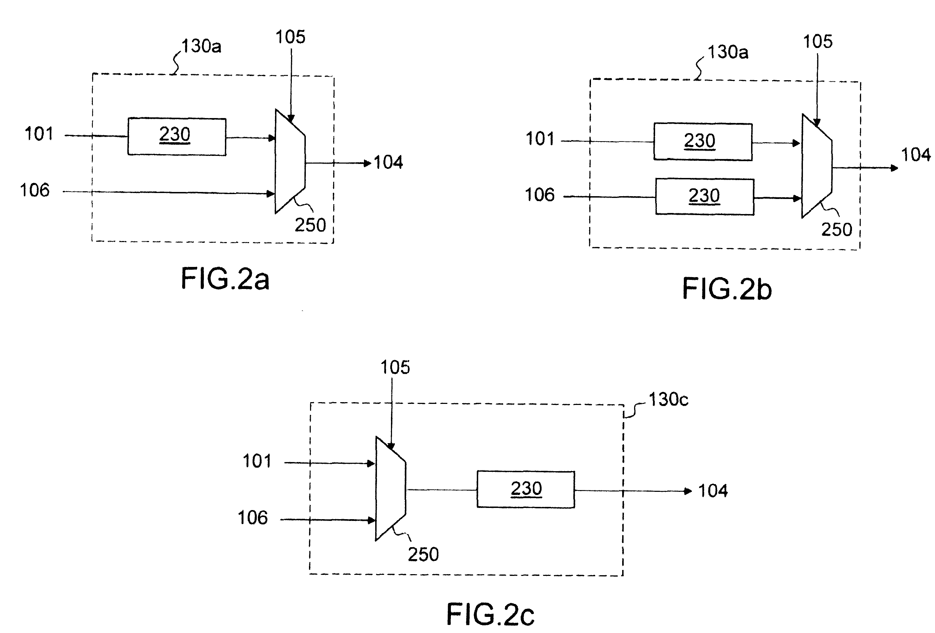

Les figures 2a, 2b, 2c illustrent plusieurs mises en oeuvre possibles des moyens de multiplexage et de correction 130 introduits dans la figure 1.

La figure 2a présente de premiers moyens de multiplexage et de correction 130a comprenant un multiplexeur 250 à deux entrées commandé par le signal de commande 105 issu des moyens de détection tels qu'illustrés en figure 1 (référence 120). Les moyens 130a comprennent également des moyens de correction d'une erreur sur maximum n-1 bits 230 placés sur la première entrée du multiplexeur 250 et alimentés par le mot initial 101. Le multiplexeur 250 est alimenté sur sa deuxième entrée par le mot intermédiaire 106. Ainsi, dans un premier cas où aucune erreur de plus de n-1 bits n'a été détectée dans le mot initial 101, le signal de commande 105 sélectionne la première entrée du multiplexeur 205 pour délivrer en sortie 104 le mot initial 101 corrigé d'une éventuelle erreur sur maximum n-1 bits ; dans un deuxième cas où une erreur d'au moins n bits a été détectée dans le mot initial 101, le signal de commande 105 sélectionne la deuxième entrée du multiplexeur 250 pour délivrer en sortie 104 le mot intermédiaire 106. La correction d'erreur double est donc effectuée par l'inversion de bits. Il est à noter que dans ce mode de réalisation, le mot corrigé 104 délivré en sortie peut encore être affecté d'une erreur, notamment dans le cas où le mot initial est affecté d'une erreur sur n bits et que le mot de confiance 102 indique un nombre de bits à faible niveau de confiance différent de n. En effet, dans ce cas, le module d'inversion 110 modifie un nombre de bits insuffisant ou trop élevé, produisant un mot intermédiaire 106 encore affecté d'une erreur malgré l'inversion de bits.

La figure 2b propose un mode de réalisation palliant les inconvénients précités du mode de réalisation de la figure 2a. Les moyens de multiplexage et de correction 130b de la figure 2 comprennent un multiplexeur 250 à deux entrées commandé par le signal de commande 105. Les moyens 130b comprennent également de premiers moyens de correction d'une erreur de n-1 bits 230 placés sur la première entrée du multiplexeur 250 et alimentés par le mot initial 101 et de deuxièmes moyens de correction d'une erreur de n-1 bits 230 placés sur la deuxième entrée du multiplexeur 250 et alimentés par le mot intermédiaire 106. Ainsi, dans un premier cas où aucune erreur de plus de n-1 bits n'a été détectée dans le mot initial 101, le signal de commande 105 sélectionne la première entrée du multiplexeur 205 pour délivrer en sortie 104 le mot initial 101 corrigé d'une éventuelle erreur sur maximum n-1 bits ; dans un deuxième cas où une erreur d'au moins n bits a été détectée dans le mot initial 101, le signal de commande 105 sélectionne la deuxième entrée du multiplexeur 250 pour délivrer en sortie 104 le mot intermédiaire 106 corrigé d'une éventuelle erreur résiduelle sur maximum n-1 bits.

La figure 2c présente un mode de réalisation des moyens de multiplexage et de correction 130c comprenant un multiplexeur 250 à deux entrées commandé par le signal de commande 105. Le multiplexeur 250 est alimenté sur sa première entrée par le mot initial 101 et sur sa deuxième entrée par le mot intermédiaire 106. Un module de correction d'une erreur de maximum n-1 bits 230 est placé en sortie du multiplexeur 250, de sorte que quel que soit le mot sélectionné en entrée - mot initial 101 ou mot intermédiaire 106 -, celui-ci est soumis au module de correction 230. Ce mode de réalisation ne constitue qu'un exemple de mutualisation des moyens de correction. Il est à noter que le mode de réalisation de la figure 2b peut parfois être préféré à celui de la figure 2c car il diminue la latence des dispositifs proposés en permettant de calculer le signal de commande 105 en parallèle avec les éventuelles corrections effectuées dans les modules 230.

La figure 3 présente un premier mode de réalisation d'un dispositif selon l'invention. Le dispositif 300 permet notamment la correction des erreurs simples et multiples (c'est-à-dire affectant un nombre de bits au moins égal à 2) dans un mot initial 101 d'un code caractérisé par une distance minimale de Hamming de 3 ou 4 (autrement dit, n est égal à 2 pour reprendre le principe décrit plus haut en regard de la figure 1). L'utilisation d'une distance minimale de Hamming égale à 4 permet à un décodeur SEC-DED de corriger des erreurs simples (c'est-à-dire lorsqu'un seul bit est erroné) et de détecter des erreurs doubles (dans le cas où deux bits sont erronés). En outre, si le code auquel appartient le mot initial 101 est imparfait et caractérisé par une distance minimale de Hamming égale à 3, alors une fraction non nulle mais différente de 100% des erreurs doubles peut être détectée. Ce dispositif 300 reçoit également un mot 102 comprenant une information relative au niveau de confiance de chaque bit dans le mot de code 101.

Le dispositif 300 comporte un décodeur SEC-DED 320 (« Single Error Correction - Double Error Detection » pour correction d'erreurs simples et détection d'erreurs doubles) alimenté par un mot initial 101, un module d'inversion de bits 310 alimenté par le mot initial 101 et le mot de confiance 102, un décodeur SEC (« Single Error Correction » pour correction d'erreurs simples) alimenté par le module d'inversion de bits 310 et un multiplexeur 340 commandé par le décodeur SEC-DED 320 d'une part, et d'autre part par le décodeur SEC 330.

Le décodeur SEC-DED 320 est configuré pour recevoir en entrée un mot de code 101, dit mot initial 101, dont certains bits peuvent être erronés. La structure du dispositif 300 correspond au cas présenté en figure 2b où les modules de correction d'erreurs sont placés sur chacune des entrées du multiplexeur. Pour faire le lien avec les schémas de principe présentés en figure 1 et 2b, le décodeur SEC-DED 320 du dispositif 300 assure cumulativement les fonctions remplies, d'une part par le module de détection 120 (cf. figure 1), et d'autre part par un module de correction 230 compris dans les moyens de correction et de multiplexage 130 (cf. figure 2b). Ces moyens de correction et de multiplexage 130 correspondent dans la figure 3 à l'association du multiplexeur 340 avec le décodeur SEC 330 et la partie du décodeur SEC-DED 320 responsable de la correction des erreurs simples. Le décodeur SEC-DED 320 permet de générer un signal de commande 305 pour contrôler le multiplexeur 340, et il permet aussi de corriger les erreurs simples dans le mot initial 101 avant que celui-ci soit transmis à une première entrée du multiplexeur 340.

Le module d'inversion de bits 310 fonctionne selon le principe déjà décrit plus haut de manière à générer un mot intermédiaire 306 en inversant les bits de faible confiance du mot initial 101. Avantageusement, le module d'inversion 310 contient des portes logiques opérant un xor (« ou exclusif ») entre chaque bit dans le mot initial 101 et le bit correspondant dans le mot de confiance 102.

Le décodeur SEC 330 est alimenté par le mot intermédiaire 306 issu du module d'inversion 310, de sorte que le décodeur SEC 330 peut corriger une erreur simple présente dans le mot intermédiaire 306.

Le multiplexeur 340 est configuré pour choisir entre la sortie du décodeur SEC-DED 320 et la sortie du décodeur SEC 330 le mot qui est transmis par la sortie 104 du dispositif 300. Grâce au signal de commande 305 généré par le SEC-DED 320, la sortie du décodeur SEC 330 est choisie seulement quand le décodeur SEC-DED 320 indique l'apparition d'une erreur non corrigible, c'est-à-dire dans l'exemple un erreur autre qu'une erreur simple (dans ce cas une erreur double) ; dans le cas contraire, la sortie du décodeur SEC-DED 320 est choisie. Le signal de commande 305 prend par exemple la valeur 1-logique quand le décodeur SEC-DED 320 indique la présence d'une erreur non corrigible. Dans tous les cas, le multiplexeur 340 délivre en sortie un mot corrigé 104, même si dans de rares cas, correspondant par exemple à des cas où le mot initial était affecté de nombreux bits de faible confiance, le dispositif selon l'invention ne parvient pas à générer un mot corrigé 104 exempt d'erreurs.

La réalisation des décodeurs SEC-DED 320 et SEC 330 n'est pas détaillée car connue de l'Homme du métier.

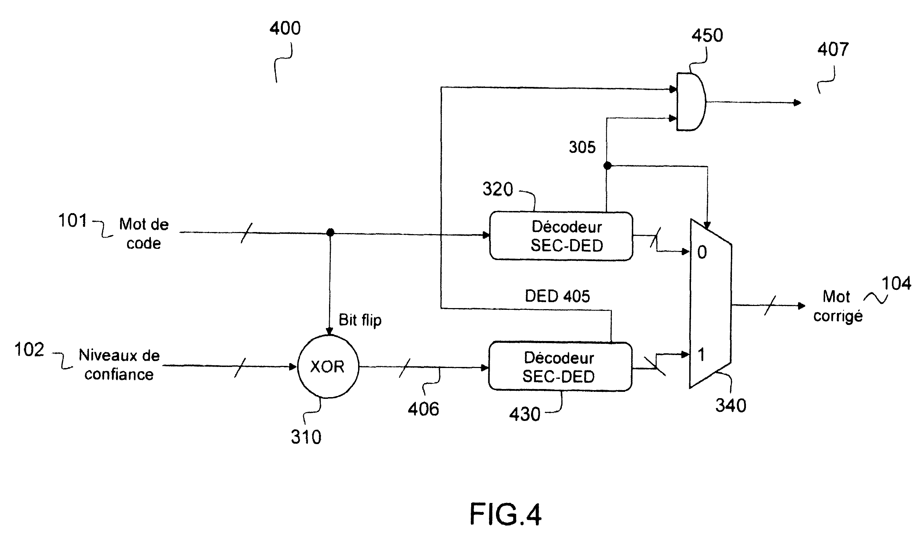

La figure 4 illustre une variante de réalisation du dispositif présenté en figure 3 permettant en outre la détection des erreurs n'ayant pas pu être corrigées. Le dispositif 400 comporte, par rapport au dispositif de la figure 3, une sortie supplémentaire 407 indiquant la présence ou non d'une erreur n'ayant pu être corrigée par le dispositif.

Par rapport au dispositif présenté en figure 3, le décodeur SEC 330 est remplacé par un décodeur SEC-DED 430 qui a les mêmes propriétés que le décodeur SEC-DED 320 présenté plus haut. Comme en figure 3, les bits du mot de code 101 sont inversés par le module 310 en fonction des bits contenus dans le mot 102, indicateur de confiance, pour donner les bits du mot intermédiaire 406, lequel est transmis au décodeur SEC-DED 430. Ce décodeur SEC-DED 430 est configuré pour émettre un signal d'erreur 405 lorsqu'il détecte une erreur non corrigible. Ce signal d'erreur 405 est combiné au signal de commande 305 émis par le premier SEC-DED 320 pour générer un signal 407 de sortie indiquant une erreur non corrigible par le dispositif.

Les signaux 305 et 405 prennent par exemple la valeur 1-logique seulement quand les décodeurs SEC-DED 320 et, respectivement SEC-DED 430, indiquent la présence d'une erreur qui n'a pas été corrigée. Ces signaux 305 et 405 peuvent être combinés par une opération de « et-logique » 450 pour produire le signal d'erreur 407 en sortie du dispositif.

Les dispositifs illustrés en figures 3 et 4 peuvent corriger une erreur double si au moins un des deux bits affectés par cette erreur double dans le mot initial 101 est indiqué par le mot 102 comme ayant un faible niveau de confiance. Dans le cas où un seul de ces deux bits est indiqué comme ayant un faible niveau de confiance, il faut qu'il soit le seul bit dans tout le mot de code 101 qui soit indiqué comme tel pour que l'erreur double devienne corrigible.

Dans les dispositifs illustrés en figures 3 et 4, les décodeurs SEC-DED peuvent être construits de façon à assurer aussi la détection des erreurs affectant plus de deux bits qui sont caractérisées par un syndrome non nul et différent des syndromes correspondants à une erreur simple. Ainsi ces dispositifs peuvent assurer la correction de toutes les erreurs détectables dont certaines affectent plus de deux bits.

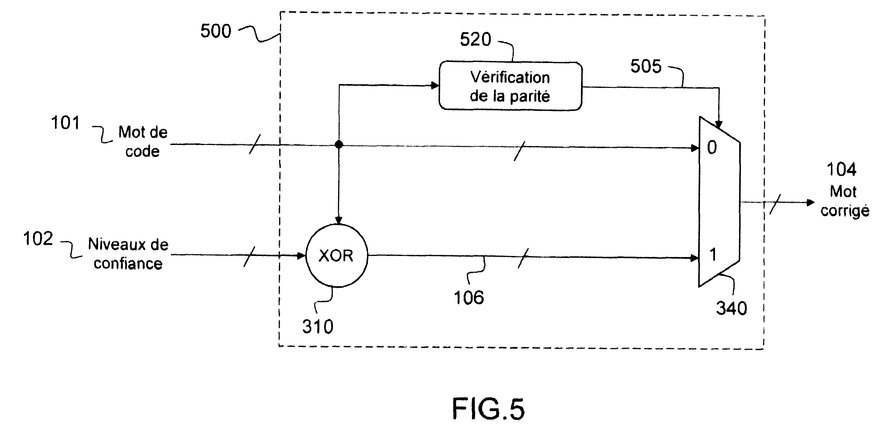

La figure 5 présente un exemple de dispositif pour la correction des erreurs simples dans un mot de code 101 contenant un bit de parité ou d'imparité qui garantit la même parité pour tous les mots de code sans erreurs, c'est-à-dire des mots de code séparés par une distance minimale de Hamming de 2 (autrement dit, n est égal à 1 pour reprendre le principe décrit plus haut en regard de la figure 1). Ce dispositif 500 reçoit également un mot 102 comprenant une information relative au niveau de confiance de chaque bit dans le mot de code 101.

Le dispositif 500 de la figure 5 comporte au moins un module d'inversion 310, un multiplexeur 340 et un module de vérification de parité 520. Le module d'inversion 310 et le multiplexeur 340 remplissent les mêmes fonctions que dans les figures précédentes.

Le module de vérification 520 de la parité est configuré pour déterminer la parité totale du mot initial 101 et générer un signal 505 de parité pour commander le multiplexeur 340. La sortie 505 du module 520 prend par exemple la valeur 1-logique seulement quand la parité du mot initial 101 ne correspond pas à la parité d'un mot de code sans erreurs. Un homme du métier peut aisément identifier toutes les modifications nécessaires dans le cas où les valeurs de cette sortie 505 sont inversées. La sortie du module d'inversion 310 est choisie par le multiplexeur 340 seulement quand le signal de contrôle 505 indique une disparité entre la parité actuelle et la parité attendue du mot initial 101 donc l'apparition d'une erreur ; dans le cas contraire le mot initial 101 est choisi pour la sortie 104 du dispositif 500. Le multiplexeur 340 délivre en sortie le mot corrigé 104 en excluant, éventuellement, le bit de parité.

Par rapport au dispositif de la figure 3, le décodeur SEC 330 est remplacé par un « correcteur 0-bit », autrement dit un fil (le fil sur lequel transite le mot 106 issu du module d'inversion 310 pour alimenter le multiplexeur 340). De même, au lieu de transmettre le mot initial 101 vers un décodeur SEC-DED 320, le mot initial 101 est transmis au multiplexeur par un fil (correcteur 0-bit). Pour faire le lien avec les schémas de principe présentés en figure 1 et 2b, le module de vérification de la parité 520 correspond au module de détection 120 (cf. figure 1) et le module de correction 230 (cf. figures 2a, 2b, 2c) correspond à un correcteur 0-bit, c'est-à-dire un fil.

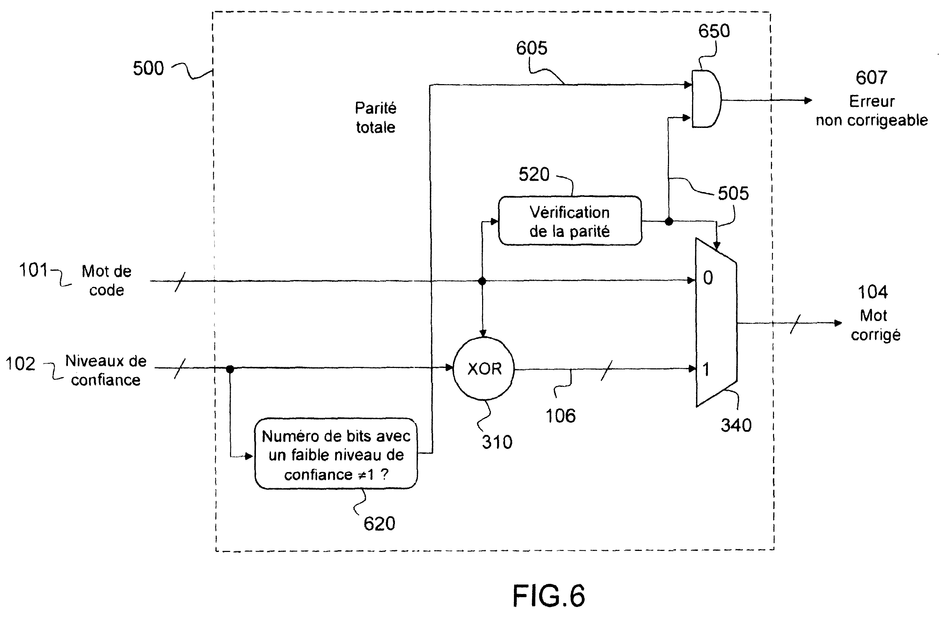

La figure 6 illustre une variante du dispositif de la figure 5 qui permet également la détection des erreurs simples n'ayant pas pu être corrigées.

Par rapport au dispositif 500 présenté en figure 5, le dispositif 600 comprend en plus un module de test 620 afin de vérifier si le mot 102 indicateur de confiance indique un seul bit avec un faible niveau de confiance dans le mot de code 101. La sortie 605 du module 620 prend par exemple la valeur 0-logique seulement quand le mot de confiance 102 indique la présence d'un seul bit avec un faible niveau de confiance dans le mot de code 101.

Dans l'exemple, les sorties des modules de vérification de parité 520 et de test 620 sont combinées dans un module 650 implémentant une opération de et-logique. La sortie 607 du module et-logique 650 permet ainsi d'indiquer la présence d'une erreur qui n'a pas été corrigée.

Avantageusement, les modules d'inversion, de multiplexage, de décodage qui sont utilisés dans les modes de réalisation présentés du dispositif selon l'invention sont des modules standards connus de l'état de l'art. En outre, l'homme du métier peut aisément identifier les modifications nécessaires aux dispositifs proposés dans le cas où un faible niveau de confiance est indiqué par la valeur 0-logique au lieu de la valeur 1-logique comme dans les exemples précédents.

## Revendications

1. Dispositif de correction (300) d'un mot binaire initial (101) affecté d'une erreur sur 1 ou 2 bits et issu d'un code correcteur muni d'une distance minimale de Hamming de 3 ou 4, le dispositif comprenant un premier moyen de correction et détection (320), étant de correction d'une erreur de 1 bit et de détection d'une erreur de plus de 1 bit dans le mot initial (101), et un deuxième moyen de correction (330) d'une erreur de 1 bit dans un mot (306) issu d'un module d'inversion (310), ledit module d'inversion (310) étant apte à recevoir une donnée indicative d'un niveau binaire de confiance (102), faible ou fort, attribué à chacun des bits d'au moins une partie du mot initial (101), ledit module d'inversion (310) étant configuré pour inverser les bits du mot initial (101) qui sont affectés du niveau de confiance faible, le dispositif comprenant également un multiplexeur (340) à au moins deux entrées commandé par le premier moyen de correction et détection, ledit multiplexeur (340) étant alimenté sur une première entrée par la sortie du premier moyen de correction et détection (320) et sur une deuxième entrée par la sortie du deuxième moyen de correction (330), le premier moyen de correction et détection (320) étant adapté à générer un signal de commande (305)
afin de choisir la sortie du deuxième moyen de correction (330) dans le cas où le premier moyen de correction et détection (320) détecte une erreur de plus de 1 bit dans le mot initial, et dans le cas contraire, la sortie du premier moyen de correction et de détection (320) est choisie.

2. Dispositif de correction (400) d'un mot initial (101) selon la revendication 1 **caractérisé en ce que** le deuxième moyen de correction est un moyen de correction d'une erreur simple et de détection d'une erreur de plus de 1 bit (430), les sorties des deux moyens de correction et de détection (320, 430) étant combinées (450) pour générer un signal (407) indiquant une erreur incorrigible lorsque les deux moyens de détection (320, 430) ont détecté une erreur de plus de 1 bit.

3. Dispositif selon la revendication 2, selon lequel les moyens de détection (320, 430) d'une erreur de plus de 1 bit du premier et du deuxième moyen de correction et détection sont configurés pour détecter des erreurs affectant plus de deux bits qui sont **caractérisées par** un syndrome non nul et différent des syndromes correspondants à une erreur simple.

4. Module mémoire comprenant un dispositif selon l'une quelconque des revendications précédentes.

## Patentansprüche

1. Vorrichtung (300) zum Korrigieren eines binären Anfangsworts (101) mit einem Fehler an 1 oder 2 Bits, das von einem Korrekturcode mit einer minimalen Hamming-Distanz von 3 oder 4 stammt, wobei die Vorrichtung ein erstes Korrektur- und Detektionsmittel (320) zum Korrigieren eines Fehlers von 1 Bit und zum Detektieren eines Fehlers von mehr als 1 Bit in dem Anfangswort (101) umfasst,
und ein zweites Mittel (330) zum Korrigieren eines Fehlers von 1 Bit in einem Wort (306), das von einem Umkehrmodul (310) kommt, wobei das Umkehrmodul (310) ein Datenelement empfangen kann, der ein niedriges oder hohes binäres Konfidenzniveau (102) anzeigt, das jedem Bit von wenigstens einem Teil des Anfangsworts (101) zugeordnet ist, wobei das Umkehrmodul (310) zum Umkehren der Bits des Anfangsworts (101) konfiguriert ist, die von dem niedrigen Konfidenzniveau betroffen sind, wobei die Vorrichtung ferner einen Multiplexer (340) mit wenigstens zwei Eingängen umfasst, der von dem ersten Korrektur- und Detektionsmittel gesteuert wird,
wobei der Multiplexer (340) an einem ersten Eingang mit dem Ausgang des ersten Korrektur- und Detektionsmittels (320) gespeist wird und an einem zweiten Eingang mit dem Ausgang des zweiten Korrekturmittels (330) gespeist wird, wobei das erste Korrektur- und Detektionsmittel (320) zum Erzeugen eines Steuersignals (305) ausgelegt ist, um den Ausgang des zweiten Korrekturmittels (330) zu wählen, falls das erste Korrektur- und Detektionsmittel (320) einen Fehler von mehr als 1 Bit in dem Anfangswort detektiert, und ansonsten der Ausgang des ersten Korrektur- und Detektionsmittels (320) gewählt wird.

2. Vorrichtung (400) zum Korrigieren eines Anfangsworts (101) nach Anspruch 1, **dadurch gekennzeichnet, dass** das zweite Korrekturmittel ein Mittel zum Korrigieren eines einzelnen Fehlers und zum Detektieren eines Fehlers von mehr als 1 Bit (430) ist,
wobei die Ausgänge der zwei Korrektur- und Detektionsmittel (320, 430) kombiniert (450) werden, um ein Signal (407) zu erzeugen, das einen unkorrigierbaren Fehler anzeigt, wenn die zwei Detektionsmittel (320, 430) einen Fehler von mehr als 1 Bit detektiert haben.

3. Vorrichtung nach Anspruch 2, wobei das Mittel (320, 430) zum Detektieren eines Fehlers von mehr als 1 Bit des ersten und zweiten Korrektur- und Detektionsmittels zum Detektieren von Fehlern konfiguriert sind, die mehr als zwei Bits betreffen, die durch ein Nicht-Null-Syndrom charakterisiert sind und sich von Syndromen unterscheiden, die einem einzelnen Fehler entsprechen.

4. Speichermodul, das eine Vorrichtung nach einem der vorherigen Ansprüche umfasst.

## Claims

1. A device (300) for correcting an initial binary word (101) affected by an error on 1 or 2 bits and originating from a correction code with a minimum Hamming distance of 3 or 4, the device comprising a first correction and detection means (320) for correcting an error of 1 bit and for detecting an error of more than 1 bit in the initial word (101),
and a second means (330) for correcting an error of 1 bit in a word (306) coming from an inversion module (310), said inversion module (310) being able to receive a data item indicating a low or high binary confidence level (102) assigned to each bit of at least one part of said initial word (101), said inversion module (310) being configured to invert the bits of said initial word (101) that are assigned the low confidence level, the device further comprising a multiplexer (340) with at least two inputs controlled by the first correction and detection means,
said multiplexer (340) being fed on a first input by the output of the first correction and detection means (320) and on a second input by the output of the second correction means (330), the first correction and detection means (320) being adapted to generate a control signal (305) in order to select the output of the second correction means (330) in the event that the first correction and detection means (320) detects an error of more than 1 bit in said initial word and, otherwise, the output of the first correction and detection means (320) is selected.

2. The device (400) for correcting an initial word (101) according to claim 1, **characterised in that** the second correction means is a means for correcting a single error and for detecting an error of more than 1 bit (430),
the outputs of the two correction and detection means (320, 430) being combined (450) in order to generate a signal (407) indicating an uncorrectable error when the two detection means (320, 430) have detected an error of more than 1 bit.

3. The device according to claim 2, wherein the means (320, 430) for detecting an error of more than 1 bit of the first and of the second correction and detection means are configured to detect errors affecting more than two bits that are **characterised by** a non-zero syndrome and differ from syndromes that correspond to a single error.

4. A memory module comprising a device according to any one of the preceding claims.
